# EUROPEAN PATENT APPLICATION

(11) **EP 0 817 557 A2**
(43) Date of publication of application: **07.01.1998**
(21) Application number: 97304304.5
(22) Date of filing: 19.06.1997
(51) Int. Cl.: H05K 9/00

(54) **Electromagnetic radiation shield material and method of producing the same**

(30) Priority: 03.07.1996 JP 191677/96
(71) Applicant: NISSHINBO INDUSTRIES, INC., Tokyo 103 (JP)
(72) Inventor: Marutsuka, Toshinori, c/o Nisshinbo Ind., Inc., Adachi-ku, Tokyo (JP)
(74) Representative: Stuart, Ian Alexander

(57) **Abstract**

A transparent electromagnetic radiation shield material for placement in front of a display device or other such source of electromagnetic radiation to shield the viewer from electromagnetic radiation while enabling the display to be viewed therethrough is provided, which transparent electromagnetic radiation shield material is produced by the steps of applying to the surface of a transparent base material a resin solution containing a reduction metal, drying the applied solution to form a coating, optionally subjecting the coating to reduction treatment as required, forming an electroless plating layer on the entire surface of the coating while simultaneously blackening the coating, forming a desired resist pattern on the electroless plating layer, and removing portions of the electroless plating layer where no resist is present and blackened portions of the coating thereunder by etching. A metallic salt or a metal complex or particles of a reduced metal particles are used as the reduction metal.

## Description

This invention relates to a transparent electromagnetic radiation shield material, more particularly to a transparent electromagnetic radiation shield material for placement in front of a display device or other such source of electromagnetic radiation to shield the viewer from electromagnetic radiation, and to a method of producing the same.

An electromagnetic radiation shield material for placement in front of a display device or other source of electromagnetic radiation is required to have excellent transparency and wide viewing angle in addition to excellent electromagnetic radiation shielding capability. Japanese Patent Application Laid-Open No. 5-16281 teaches an electromagnetic radiation shield material meeting these requirements.

According to the disclosed invention, a transparent acrylic sheet or plate is coated with cellulose acetate propinate to form a hydrophilic transparent resin layer thereon. After being air-dried, the coated sheet or plate is soaked in hydrochloric acid palladium colloid catalyst solution to form electroless plating nuclei in the hydrophilic transparent resin, washed with water and subjected to electroless copper plating. The electroless plating is then patterned by etching by the resist method using ferric chloride. The surface of the electroless plating exhibits metallic luster while the hydrophilic transparent resin layer under the patterned electroless plating exhibits black patterning.

This prior-art invention, however, requires the hydrophilic transparent resin to be formed with electroless plating nucleus catalyst by soaking in hydrochloric acid palladium colloid catalyst solution before the electroless plating step.

Since electroless plating nuclei are adsorbed on both surfaces of the substrate and both surfaces are plated by this method, however, the plating cost is high. An attempt to reduce the plating cost by plating only the coated surface is ineffective, however, since it requires the opposite surface to be treated to prevent plating, which increases the number of processing steps and increases production cost. Another problem with the method is that the soaking of the substrate in the catalyst solution markedly degrades adhesion between the coating and the substrate.

Moreover, since the impregnation of the coating with catalyst is effected by soaking the substrate in a catalyst solution, uniform catalyst distribution in the thickness direction of the coating is hard to achieve. The blackening of the coating by plating is therefore difficult to conduct stably and efficiently. The method is also poor in product yield because defects tend to arise during patterning of the plating owing to the unevenness of the plating adhesion.

The present invention provides a method of producing a transparent electromagnetic radiation shield material comprising the steps of applying to the surface of a transparent base material a resin solution containing a reduction metal, drying the applied solution to form a coating, optionally subjecting the coating to reduction treatment as required, forming an electroless plating layer on the entire surface of the coating while simultaneously blackening the coating, forming a desired resist pattern on the electroless plating layer, and removing portions of the electroless plating layer where no resist is present and blackened portions of the coating thereunder by etching.

The reduction metal is a metallic salt and/or a metal complex and/or particles of a reduced metal. Generally the reduction metal consist of metal particles and/or metal species reducible to form metal particles in the method.

In a preferred aspect of the invention, the reduction metal is (1) a metallic salt or a metal complex [A] which can be reduced with a reducing agent only in the presence of a catalyst and a metallic salt or a metal complex [B] which can be directly reduced or (2) the metallic salt or the metal complex which can be reduced with a reducing agent only in the presence of a catalyst and reduced metal particles [C].

In another preferred aspect of the invention, the transparent electromagnetic radiation shield material is produced by applying to the surface of the transparent base material a resin solution containing reduced metal particles, drying the applied solution to form the coating, optionally subjecting the coating to activation treatment as required, forming the electroless plating layer on the entire surface of the coating while simultaneously blackening the coating, forming the desired resist pattern on the electroless plating layer, and removing portions of the electroless plating layer where no resist is present and blackened portions of the coating thereunder by etching.

In another preferred aspect of the invention, the transparent electromagnetic radiation shield material is produced by applying to the surface of the transparent base material a resin solution having dissolved or dispersed therein the metallic salt or the metal complex [A] and the metallic salt or the metal complex [B], or the metal complex [A] and the reduced metal particles [C], drying the applied solution to form the coating, subjecting the coating to reduction treatment, forming the electroless plating layer on the entire surface of the coating while simultaneously blackening the coating, forming the desired resist pattern on the electroless plating layer, and removing portions of the electroless plating layer where no resist is present and blackened portions of the coating thereunder by etching.

In another preferred aspect of the invention, the metallic salt or the metal complex is a salt or a complex of a metal belonging to Group Ib or Group VIII of the Periodic Table of the Elements.

In another preferred aspect of the invention, the reduced metal particles are reduced metal colloid particles or reduced metal powder obtained from a dispersion of a metal belonging to Group Ib or Group VIII of the Periodic Table of the Elements.

In another preferred aspect of the invention, the metallic salt or the metal complex [A] is a metallic salt or a metal complex of a metal belonging to the Fourth Period of Group Ib or the Fourth Period of Group VIII of the Periodic Table of the Elements, the metallic salt or the metal complex [B] is a metallic salt or a metal complex of a metal belonging to the Fifth or Sixth Period of Group Ib or the Fifth or Sixth Period of Group VIII of the Table, and the reduced metal particles [C] are reduced metal colloid particles or reduced metal powder obtained from a dispersion of a metal belonging to Group Ib or Group VIII of the Table.

In another preferred aspect of the invention, the resin of the resin solution is a polyvinyl acetal.

In another preferred aspect of the invention, the reducing agent is a compound capable of reducing [A] only in the presence of a catalyst and capable of directly reducing [B].

In another preferred aspect of the invention, the amount of the reduced metal in the coating accounted for by Pd is 1-200 mg/m² (weight per unit area of the coating) calculated as PdCl₂.

In another preferred aspect of the invention, the transparent base material is glass plate, plastic film, plastic sheet or plastic plate.

In another preferred aspect, the transparent electromagnetic radiation shield material exhibits an optical transmittance of not less than 65 % and a shielding performance of 40-80 dB in the range of 30 to 1,000 MHz.

The invention further provides an electromagnetic radiation shield material whose coating has a degree of blackness viewed from the side of a transparent substrate, expressed as optical density, of 2.9-4.0 (angle of incidence of 7 °; assuming no specular component).

### DETAILED DESCRIPTION OF THE PREFERRED EMBODIMENTS

The base material of the electromagnetic radiation shield material according to this invention is required to be transparent. It is selected according to intended use from among various materials including, for example, glass plate, plastic film, plastic sheet and plastic plate. The shape of the base material is not particularly limited.

A plastic used as the base material is preferably a resin with high transparency. Preferable examples include acrylic resins, polycarbonate, polyethylene, AS resins, vinyl acetate resin, polystyrene, polypropylene, polyester, polysulfone, polyethersulfone, polyvinylchloride, olefine-maleimide copolymer, and norbornene resins. Among these, olefine-maleimide copolymer and norbornene resins are particularly preferable owing to their high heat resistance.

The plastic should preferably have a thermal-deformation temperature of 140-360 °C, a coefficient of thermal linear expansion of not greater than 6.2x10⁻⁵cm/cm · °C, a pencil hardness of not less than 2H, a bending strength of 1,200-2,000 kgf/cm², a modulus of elasticity in bending of 30,000-50,000 kgf/cm², and a tensile strength of 700-1,200 kgf/cm². A plastic with these properties is resistant to scratching and high-temperature warping, and can therefore be used in a wide range of environments.

The plastic preferably has a light transmittance of not less than 90 %, an Abbe's number of 50-70 and a photoelasticity constant (glass region) of an absolute value of not greater than 10x10⁻¹³cm²/dyne. A plastic with these properties exhibits high transparency (is bright) and little birefringence (is not likely to produce a double image), and therefore does not degrade the image quality, brightness etc. of the display.

The resin contained in the resin solution for coating the base material may be of any type insofar as it exhibits the required transparency as well as good solubility or good dispersibility in metallic salt or metal complex or reduced metal particles.

For impregnation of the resin with the plating solution so that the reduced metal particles (plating catalyst) form nuclei and react to cause blackening by deposition of the plating metal, the resin used is preferably a hydrophilic transparent resin. Preferable hydrophilic transparent resins include vinyl acetal resins, vinyl alcohol resins, acrylic resins, cellulose resins and the like. Among these, vinyl acetal resins such as polyvinyl butyral and cellulose resins such as cellulose acetate butylate are particularly preferred.

The reduction metal particles used in this invention are particles of a metallic salt or a metal complex or particles of a reduced metal. The metallic salt or metal complex is preferably an organic or inorganic metallic salt or complex, more preferably an inorganic salt, easily reducible to a metal by a reducing agent (described later) and soluble in a common solvent (described later) with the resin. Specific examples include sulfates, nitrates, chlorides, organic salts (e.g., acetates), benzonitrile complexes, acetylacetonate complexes and ammonia complexes of iron, copper, nickel, cobalt, palladium and other elements belonging to Group Ib and Group VIII of the Periodic Table of the Elements.

The reduced metal particles used in this invention are colloid particles contained in a reduced metal colloid dispersion or reduced metal powder particles obtained from the metal colloid dispersion. Insofar as they exhibit plating catalytic activity and are uniformly dispersible in the coating, they are not particularly limited as regards type of metal or grain size. They preferably have high stability with respect to air and humidity. Specific examples of usable reduced metal particles include metals belonging to Group VIII of the Periodic Table of the Elements (Ni, Co, Rh, Pd etc.). Reduced Pd colloid particles and reduced Pd powder obtained therefrom are particularly preferable. The reduced metal colloid particles can be produced by the method described in Japanese Patent Application Laid-Open No. 1-315334. Specifically, a colloid dispersion can be obtained by reducing a salt of the metal in a mixed solvent consisting of a lower alcohol and an aprotic polar compound.

In the case of using a metallic salt or metal complex which can be reduced with a reducing agent only in the presence of catalyst (hereinafter called [A]) and a metallic salt or a metal complex which can be directly reduced (hereinafter called [B]), or of using [A] and reduced metal particles (hereinafter called [C]), specific examples of [A] include salts and complexes of iron, cobalt, nickel, copper and other metals belonging to the Fourth Period of Group Ib or the Fourth Period of Group VIII of the Periodic Table of the Elements, including sulfates, nitrates, chlorides, organic salts, benzonitrile complexes, acetylacetonate complexes and ammonia complexes.

The statement that [A] "can be reduced with a reducing agent only in the presence of catalyst" means that a catalyst is required for reduction of [A], the reducing catalyst being the reduced metal resulting from reduction of [B] as described later or the reduced metal particles [C]. [A] is therefore preferably subjected to reduction by use together with [B] or [C].

The statement that [B] is "a metallic salt or a metal complex which can be directly reduced" means that a catalyst is not required for reduction of [B], which is, for example, a salt or complex of rhodium, palladium, silver, platinum, gold or other metal belonging to the Fifth or Sixth Period of Group Ib or the Fifth or Sixth Period of Group VIII of the Periodic Table of the Elements.

As [C] there can be used the same reduced metal particles as mentioned earlier.

The amount used of the metallic salt or metal complex [A], the metallic salt or metal complex [B] or the reduced metal particles [C] in independent use or the total amount used of [A] and [B], or [A] and [C] in combined use is preferably in the range of 0.5-100 PHR (parts by weight based on 100 parts of resin), more preferably 1-50 PHR.

When the amount used is less than 0.5 PHR, the plating is coarse and lacks luster. An amount exceeding 100 PHR degrades the coating property.

Although the mechanism by which the invention produces its effect has not been completely ascertained, it is thought that the effect is obtained because, unlike in the case where a mixed state of the reduced metal particles of [A] and [B] or [A] and [C] arises owing to direct reduction of [A] by a strong reducing agent, in this invention, [A] is reduced in the presence of the reduced metal particles of [B] or [C] by the catalytic activity thereof so that the reduced metal of [A] surrounds the reduced metal particles of [B] or [C].

Since the particle diameter therefore becomes relatively large, the plating adherence is improved by the anchor effect.

The particle diameter can be controlled by varying the value of [A]/[B] or [A]/[C].

Decreasing the amount of [A] in the ratio [A]/[B] or [A]/[C] defeats the invention purpose of enabling use of [A], while decreasing the amount of [B] or [C] lowers the amount of reducing catalyst for [A] and thus prevents [A] from being utilized to full effect.

The solvent for the resin solution in this invention can be of any type insofar it can dissolve or be used to prepare a dispersion of the resin, the metallic salt or metal complex [A], the metallic salt or metal complex [B], or the reduced metal particles [C].

Preferable solvents include one or a mixture of two or more of, for example, methanol, ethanol, chloroform, methylene chloride, trichloroethylene, tetrachloroethylene, benzene, toluene, xylene, acetone, ethyl acetate, dimethylformamide, dimethylsulfoxide, dimethylacetamide and N-methylpyrrolidone.

A solvent appropriate for the combination of resin and metallic salt or metal complex and/or reduced metal particles is selected.

The amount of solvent used is selected so as to obtain an appropriate viscosity and fluidity and to make the solution appropriate for application to the base material.

The solution of the resin and metallic salt or metal complex and/or reduced metal particles is applied to a base material of desired configuration and dried to form a coating containing the metallic salt or metal complex and/or reduced metal particles. The application of the solution can be carried out by brush coating, spraying, dipping, roller coating, calender coating or other conventional method selected in view of the shape of the base material.

The conditions (temperature, time etc.) for film formation are determined based on the type and concentration of the resin, the film thickness and the like. The nonvolatile content of the solution is normally 0.05-20 wt%. The coating thickness is 0.2-10 µm, preferably 0.5-5 µm.

The reduction is generally conducted after final curing but can also be conducted in the course of curing. The treatment with the reducing agent causes the metallic salt or metal complex in the coating to deposit as reduced metal within or at the surface of the coating. The deposited metal is the plating catalyst. The metal deposited at the surface partially projects from the surface to form a reduced metal plating catalyst layer partially embedded in and integral with the coating.

Owing to the catalytic effect and the anchoring effect of the projecting portions, the plating adherence is excellent and no etching (surface roughening) is required.

Preferable reducing agents for reducing the metallic salt or metal complex include sodium borohydride, lithium borohydride, aminoborane, dimethylaminoborane and other borohydrides, ferrous salts such as FeSO₄, hydrogenphosphate metallic salts such as sodium hypophosphite, hydroxylamine sulfate, hydrosulfite, formalin and the like. A borohydride is generally preferable.

In the case of [A] and [B], or [A] and [C], the reducing agent is preferably a compound capable of directly reducing [B] and also capable of reducing [A] with catalyst.

Reducing agents that can be preferably used include, for example, sodium hypophosphite, dimethylaminoborane, formalin and the like.

Although the solvent used to prepare the reducing agent solution is generally water, it is not limited to water and an organic solvent or any other solvent system capable of dissolving or dispersing the reducing agent can be used instead. The concentration of the reducing agent in the reducing agent solution is generally 0.05-50 wt%, preferably 0.1-25 wt%.

The reduction can be easily conducted by, for example, immersing the substrate bearing the coating containing the metallic salt or metal complex and/or reduced metal particles in the reducing agent solution for an appropriate period of time or spraying it with the reducing agent solution.

The reduction temperature is preferably 10-90 °C and the period of contact with the reducing agent solution is preferably on the order of several tens of seconds to 30 minutes.

The solvent can be completely removed from the coating before the reduction or part of the solvent may be allowed to remain therein. Leaving part of the solvent in the coating facilitates permeation of the reducing agent into the coating.

When the solvent is completely removed from the coating, the reduction efficiency can be increased by such methods as increasing the temperature of the reducing agent solution, preheating the coating before reduction, treating the coating with a solution that causes it to swell, or using a reducing agent solution whose solvent is similar to and exhibits good affinity for the resin solvent.

The reduction is ordinarily conducted until at least the metallic salt or metal complex present in the surface layer has been reduced but can instead be terminated as soon as the amount of catalyst required for the plating has been secured.

When reduced metal particles are used independently, they can be treated with a reducing agent or with an acid or an alkali in order to eliminate unevenness in surface catalytic activity or enhance the degree of catalytic activity.

In one preferred embodiment of the invention, for example, the amount of the reduced metal in the coating accounted for by Pd is preferably 5-200 mg/m² (weight per unit area of the coating) calculated as PdCl₂. When the amount is less than 5mg/m², sufficient blackening is difficult to obtain, while an amount greater than 200 mg/m² is uneconomical.

The base material prepared for plating (implanted with catalyst) is transferred to the electroless plating process and subjected to desired metal plating. The electroless plating can be conducted by a conventional method selected based on intended purpose. Ni plating and Cu plating are typical examples.

In the method of this invention, the adhesion, hardness, strength, plating catalytic activity and the like of the coating prepared for plating can be adjusted by appropriately selecting the type of resin, metallic salt or metal complex and/or reduced metal particles and by varying such operating conditions as the curing and reducing agent treatment conditions.

The coating prepared for plating is next treated with an electroless plating solution to form an electroless plating layer. The coating is blackened simultaneously with the formation of the electroless plating layer. After this treatment, the portion overlaid with the electroless plating layer appears black when viewed from the side of the transparent base material.

As viewed from the side of the transparent base material (thickness: 2 mm, refractive index: 1.49, optical transmittance: 93 %, average roughness Ra: 40 Å) of the transparent electromagnetic radiation shield material, the coating preferably has a degree of blackness, expressed as optical density, of not less than 2.9 (angle of incidence of 7 °; assuming no specular component). When the optical density is less than 2.9, visibility is poor owing to the low blackness of the coating. (The intensity of plating glare increases with decreasing optical density.) When the optical density is 2.9 or greater, the blackness of the coating is adequate and visibility excellent (definition high). Visibility as perceived by the naked eye does not improve substantially above an optical density of 4.0.

Next, a resist pattern matched to electrically conductive portions of the electromagnetic radiation shield material is formed on the electroless plating layer. The resist pattern can be formed by a generally known method such as printing.

Unnecessary portions of the electroless plating layer where no resist is present and unnecessary black portions are then removed by treatment with an etching solution.

As a result, the coating is formed under the patterned electroless plating layer with black portions of the same pattern. The portions where the electroless plating layer and the black portions have been removed is transparent. The resist portions are then removed by immersion in or spraying with a exfoliating solution such as an aqueous alkali solution or other such solution capable of dissolving the resist.

The foregoing processes enable the fabrication of a transparent electromagnetic radiation shield material having conductive portions formed in a desired pattern.

The transparent electromagnetic radiation shield material preferably has an optical transmittance of not less than 65 % and a shielding performance of not less than 40 dB in the range of 30 to 1,000 MHz. An optical transmittance of less than 65% is too dark and a shielding performance of less than 40 dB does not provide a practical level of shielding.

The etching solution is selected as appropriate for the type of metal of the electroless plating layer. When the electroless plating layer metal is nickel or copper, for example, ferric chloride or the like can be used as the etching solution.

The pattern of the conductive portion of the electromagnetic radiation shield material need not necessarily be formed by etching treatment. Any of various other methods can be used instead. One such method is to form a catalyst-containing resin coating on the base material in the desired conductive portion pattern and then conduct electroless plating. This method eliminates the need for etching treatment and has the further advantage of lowering cost by reducing the amount of coating resin and catalyst required.

The invention will now be explicitly explained with reference to Examples and Comparative Examples.

### Example 1.

A coating solution was prepared by mixing an alcohol solution of polyvinylbutyral (PVB) (Denkabutyral #6000-C, product of Denki Kagaku Kogyo, Co., Ltd.) and an aqueous palladium (Pd) colloidal catalyst solution (OPC-80 Catalyst M, product of Okuno Chemical Industries Co., Ltd.) . (Coating solution composition: PVB/catalyst solution/methanol/butanol = 10/43/647/300, Pd colloid = 3 PHR (as PdCl₂))

The coating solution was applied to an A4-size acrylic plate by the bar coating method, air-dried, and then dried for 1 hr at 80 °C. The coating thickness was 1 µm.

The coated (catalyst-containing) product was directly immersed for 1 hr in a 25 °C formalin-containing Cu plating solution (OPC-700M, product of Okuno Chemical Industries Co, Ltd.). As a result, the surface of the coating on the acrylic plate exhibited a copper luster and the rear surface of the coating (as viewed from the side of the acrylic plate) exhibited a deep black color.

The plated product was coated with a positive etching photoresist (PMER P-DF40S, product of Tokyo Ohka Kogyo Co., Ltd.), prebaked (thickness: 5 µm), exposed (using a grid-like pattern mask), and developed to form a grid-like resist pattern. These processes were conducted under the conditions recommended by the manufacturer.

The resist-patterned product was immersed in etching solution (aqueous solution of 20 % ferric chloride and 1.75 % hydrochloric acid) to remove the copper plating and the blackened copper within the coating by etching, whereafter the no longer required resist was peeled off to produce a conductive pattern (electromagnetic radiation shield material).

The electromagnetic radiation shield material exhibited shielding performance of 40-80 db (30-1000 MHz) and transparency (optical transmittance) of 75 %, as well as excellent visibility coating adherence (to base material), plating adherence (to coating), and base material flatness.

### Example 2.

An electromagnetic radiation shield material was fabricated in the same manner as in Example 1 except that the coating was formed to a thickness of 0.75 µm.

### Example 3.

An electromagnetic radiation shield material was fabricated in the same manner as in Example 1 except that the coating was formed to a thickness of 0.5 µm.

### Example 4.

An electromagnetic radiation shield material was fabricated in the same manner as in Example 1 except that the coating was formed to a thickness of 0.25 µm.

### Example 5.

A coating solution was prepared as in Example 1 except that 1 PHR of Pd colloid and 14 PHR of copper sulfate was used in place of 3 PHR of Pd colloid.

This coating solution was used to fabricate an electromagnetic radiation shield material in the same manner and under the same conditions as in Example 1.

The electromagnetic radiation shield material exhibited excellent performance characteristics similar to those of that obtained in Example 1. It was superior to the electromagnetic radiation shield material of Example 1 in coating film blackness (optical density).

### Example 6.

A coating solution was prepared as in Example 1 except that 15 PHR of copper chloride was used in place of 3 PHR of Pd colloid.

This coating solution was used to form a coating in the same manner and under the same conditions as in Example 1 (coating thickness: 1 µm).

The coated product was immersed (reduced) for 10 min in a 0.5 % aqueous solution of sodium borohydride and was then plated in the same manner and under the same conditions as in Example 1 to fabricate an electromagnetic radiation shield material.

The electromagnetic radiation shield material exhibited excellent performance similar to that obtained in Example 1.

### Example 7.

A coating solution was prepared as in Example 1 except that 5 PHR of palladium acetylacetonate was used in place of 3 PHR of Pd colloid.

This coating solution was used to form a coating (coating thickness: 3 µm), the coated product was immersed (reduced) for 15 min in a 10 % aqueous solution of sodium hypophosphite (50 °C) and was then plated and otherwise processed in the same manner and under the same conditions as in Example 1 to fabricate an electromagnetic radiation shield material.

The electromagnetic radiation shield material exhibited excellent performance characteristics similar to those of that obtained in Example 1.

### Example 8.

A coating solution was prepared as in Example 1 except that 1 PHR of palladium acetate and 24 PHR of nickel acetate was used in place of 3 PHR of Pd colloid.

This coating solution was used to form a coating (coating thickness: 5 µm), the coated product was immersed (reduced) for 10 min in a 5 % aqueous solution of dimethylaminoborane (40 °C) and was then plated and otherwise processed in the same manner and under the same conditions as in Example 1 to fabricate an electromagnetic radiation shield material.

The electromagnetic radiation shield material exhibited excellent performance characteristics similar to those of that obtained in Example 1. It was superior to the electromagnetic radiation shield material of Example 1 in coating film blackness.

### Example 9.

A coating solution was prepared as in Example 1 except that cellulose acetate butylate (CAB 553-0.4, product of Eastman-Kodak Co.) was used in place of PVB.

This coating solution was used to form an electromagnetic radiation shield material in the same manner and under the same conditions as in Example 1.

The electromagnetic radiation shield material exhibited excellent performance characteristics similar to those of that obtained in Example 1. It was superior to the electromagnetic radiation shield material of Example 1 in transparency.

### Example 10.

Electromagnetic radiation shield materials were fabricated as in Example 1 except that the transparent acrylic plate of Example 1 was replaced with transparent heat-resistant plastic plates made of olefine-maleimide copolymer (TI-160, product of Tosoh, Co., Ltd.) and norbornene resins (Arton, product of Japan Synthetic Rubber Co., Ltd.).

The electromagnetic radiation shield materials exhibited excellent performance characteristics similar to those of that obtained in Example 1. They were superior to the electromagnetic radiation shield material of Example 1 in base material flatness (noticeably less warp for a base material of the same thickness and area).

When an electromagnetic radiation shield material utilizing a plastic base material low in heat resistance and rigidity is disposed in front of a (plasma) display, pronounced warping of the base material owing to heat from the display frequently causes the display to crack or produce Moire fringes. The electromagnetic radiation shield materials obtained in this Example were totally free of this problem.

### Example 11.

An electromagnetic radiation shield material was fabricated as in Example 1 except that the transparent acrylic plate of Example 1 was replaced with PET film.

The electromagnetic radiation shield material exhibited excellent performance characteristics similar to those of that obtained in Example 1. In addition, the base material (PET film) exhibited high following property, with no exfoliation or the like between the base material and the coating or between the coating and the plating being observed even under bending.

### Example 12.

An electromagnetic radiation shield material was fabricated as in Example 1 except that the copper plating solution of Example 1 was replaced with a silver plating solution (20 °C) and the aqueous solution of ferric chloride and aqueous hydrochloric acid used as the etching solution in Example 1 was replaced with a 3 % aqueous nitric acid solution.
Silver plating solution composition:

| (Silver solution) | |
|---|---|
| Silver nitrate | 3.5 g |
| Ammonia aqueous solution | Added till precipitate redissolved |
| Water | 60 ml |
| Sodium hydroxide | 2.5 g/60 ml water |

| (Reducing agent solution) | |
|---|---|
| Glucose | 45 g |
| Tartaric acid | 4 g |
| Alcohol | 100 ml |
| Water | 1000 ml |

The electromagnetic radiation shield material exhibited excellent performance characteristics similar to those of that obtained in Example 1. It was superior to the electromagnetic radiation shield material of Example 1 in electromagnetic radiation shielding property.

### Comparative Example 1.

A coating solution was prepared as in Example 1 except that water was used in place of the catalyst solution. (Coating solution composition: PVB/water/methanol/butanol = 10/43/647/300)

This coating solution was used to form a coating in the same manner and under the same conditions as in Example 1 (coating thickness: 1 µm).

The coated product was immersed for 15 min in the same catalyst solution (25 °C) as in Example 1. The coloration of the coating after the immersion (with adsorbed catalyst) was higher than that of the coating of Example 1 (with incorporated catalyst).

When copper plating was conducted in the same manner and under the same conditions as in Example 1 without activating the coating carrying the adsorbed catalyst, copper plating deposited on both surfaces. (As the deposition progressed, most of the copper plating on the uncoated surface exfoliated upon reaching a certain thickness.)

The interface between the coating and the plating layer upon completion of the plating (as viewed from the side of the acrylic plate) exhibited copper luster. In addition, the coating swelled and peeled during the copper plating (the plated product was not worth subjecting to conductive patterning treatment).

### Comparative Example 2.

An electromagnetic radiation shield material was fabricated as in Comparative Example 1 except that the immersion for imparting catalyst was conducted for 30 min.

### Comparative Example 3.

An electromagnetic radiation shield material was fabricated as in Comparative Example 1 except that the immersion for imparting catalyst was conducted for 45 min.

### Comparative Example 4.

An electromagnetic radiation shield material was fabricated as in Comparative Example 1 except that the immersion for imparting catalyst was conducted for 60 min.

The results obtained in Examples 1-12 and Comparative Examples 1-4 are compared in Tables 1 and 2. From Tables 1 and 2 it can be seen that the method of this invention provides a thin coating and enables efficient blackening with a small amount of reduced metal (catalyst).

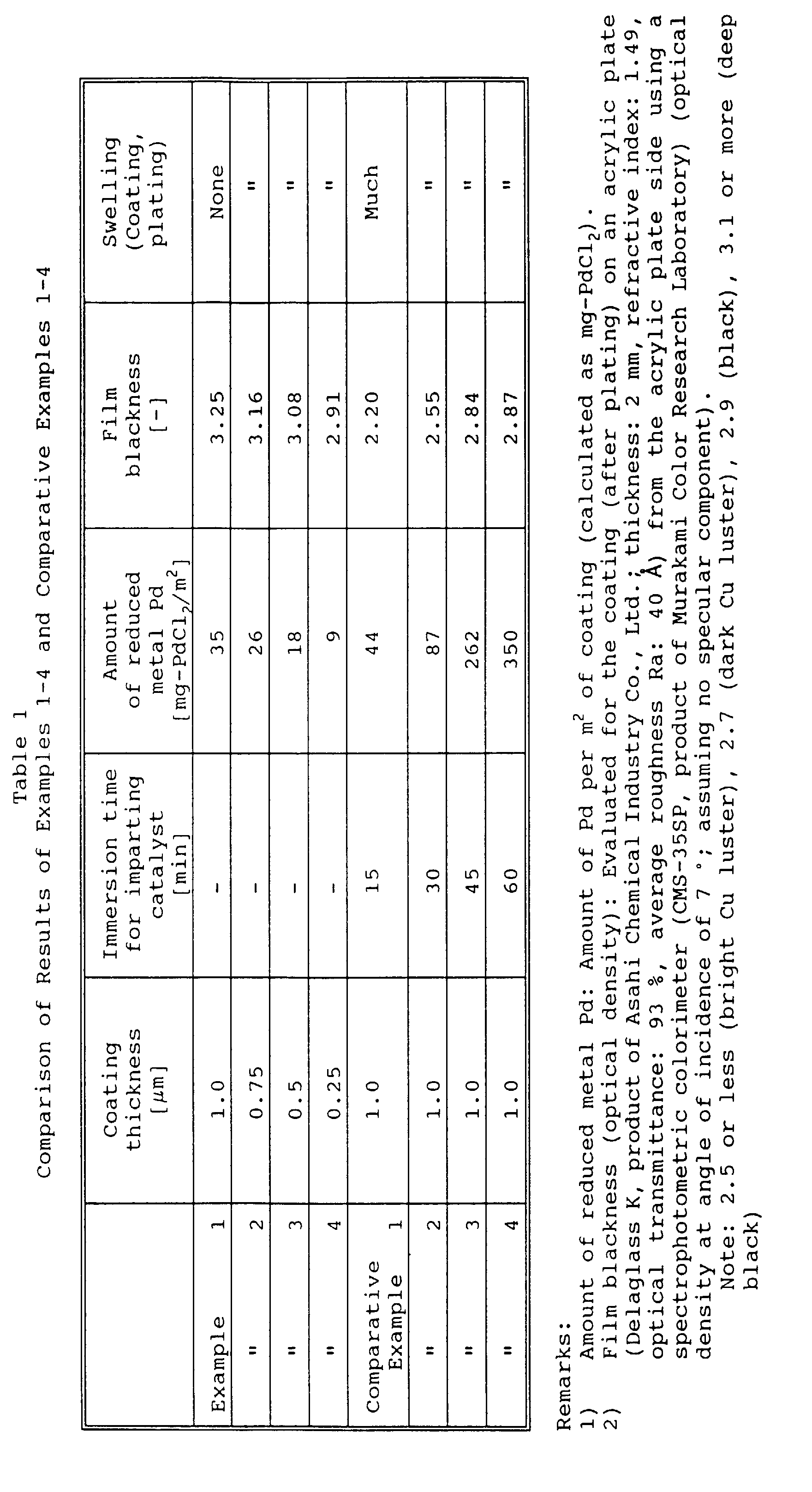

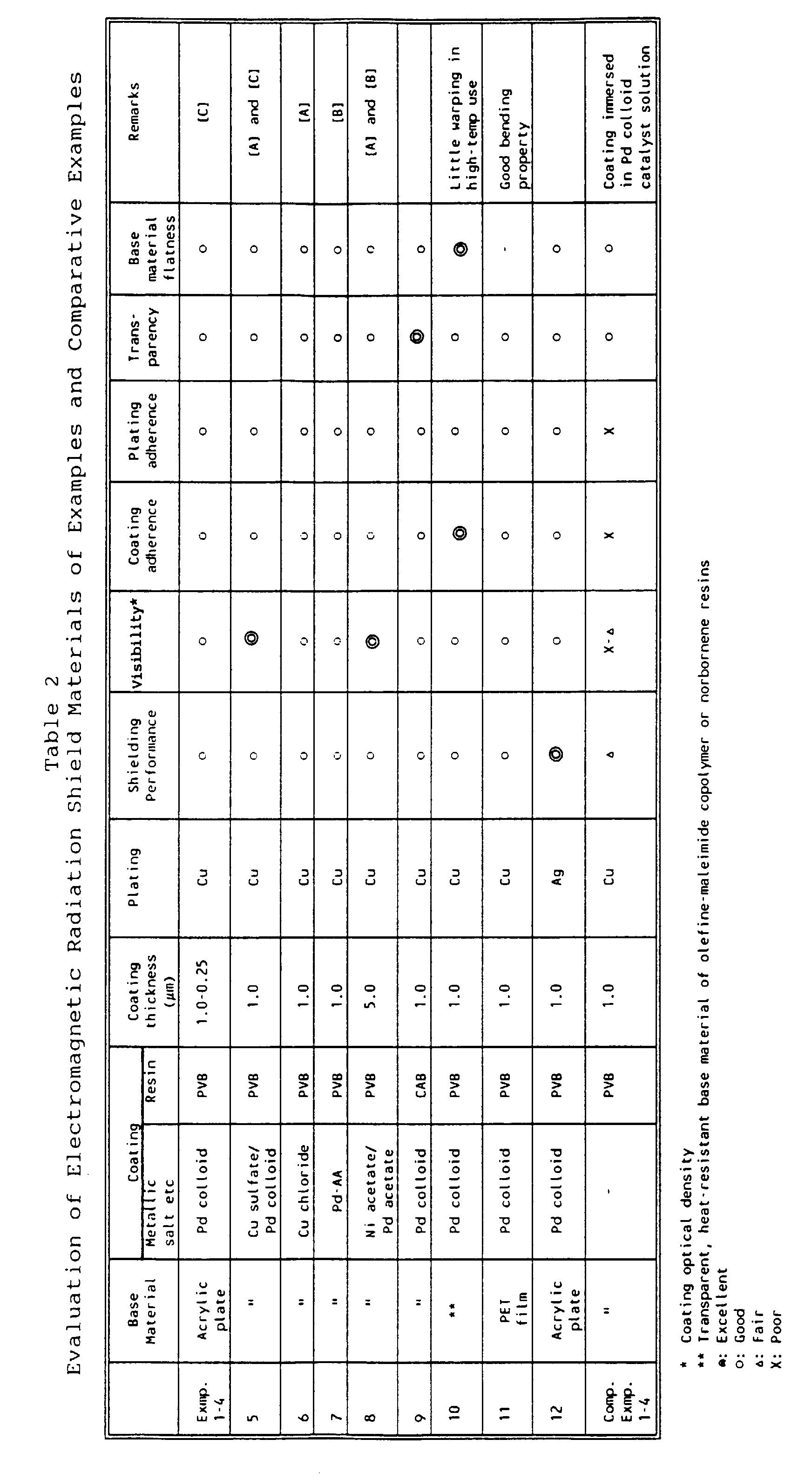

The present invention provides the following advantageous effects:
(1) Pattern design is subject to little restriction.
(2) An earth lead line can be easily connected.
(3) Conductivity is high, giving a high shielding effect.
(4) Visibility is excellent since the transparent base material side is black.
(5) Application of a black coating is unnecessary. And further:
(6) Production cost is low because the film formation and catalyst imparting (activation) steps are incorporated in the single step of forming the catalyst-containing coating.
(7) The plating cost is low because one-side plating can be achieved merely by forming the catalyst-containing coating on one side.
(8) Coating adhesion can be readily secured owing to omission of the conventional catalyst imparting step (which degrades the coating adhesion).
(9) Efficient blackening with a small amount of catalyst is possible (catalyst cost is low) because the even distribution of the catalyst in the coating ensures reliable deposition of the plating from within the coating. By the same token, the plating adhesion is high because the coating and metal are integral.
(10) In the case of using a combination of [A] and [B], or [A] and [C], by using a reducing agent capable of reducing [A] only in the presence of catalyst (and capable of directly reducing [B]), it is possible to achieve a state in which the reduced metal of [A] surrounds [B] or the reduced metal particles of [C], whereby it becomes possible to control the particle size by varying the ratio [A]/[B] or [A]/[C]. As a result, blackening of the coating can be achieved more efficiently than in the case of using [A], [B] or [C] independently. It also becomes possible to stably secure plating adhesion.

The invention thus provides numerous outstanding effects.

## Claims

1. A method of producing a transparent electromagnetic radiation shield material comprising the steps of applying to the surface of a transparent base material a resin solution containing a reduction metal, drying the applied solution to form a coating, optionally subjecting the coating to reduction treatment as required, forming an electroless plating layer on the entire surface of the coating while simultaneously blackening the coating, forming a desired resist pattern on the electroless plating layer, and removing portions of the electroless plating layer where no resist is present and blackened portions of the coating thereunder by etching.

2. A method according to claim 1, wherein the reduction metal is a metallic salt or a metal complex or particles of a reduced metal.

3. A method according to claim 1, wherein the reduction metal is (1) a metallic salt or a metal complex [A] which can be reduced with a reducing agent only in the presence of a catalyst, and a metallic salt or a metal complex [B] which can be directly reduced or (2) the metallic salt or the metal complex which can be reduced with a reducing agent only in the presence of a catalyst and reduced metal particles [C].

4. A method according to claim 2, wherein the transparent electromagnetic radiation shield material is produced by applying to the surface of the transparent base material a resin solution containing reduced metal particles, drying the applied solution to form the coating, optionally subjecting the coating to activation treatment as required, forming the electroless plating layer on the entire surface of the coating while simultaneously blackening the coating, forming the desired resist pattern on the electroless plating layer, and removing portions of the electroless plating layer where no resist is present and blackened portions of the coating thereunder by etching.

5. A method according to claim 3, wherein the transparent electromagnetic radiation shield material is produced by applying to the surface of the transparent base material a resin solution having dissolved or dispersed therein the metallic salt or the metal complex [A] and the metallic salt or the metal complex [B], or the metal complex [A] and the reduced metal particles [C], drying the applied solution to form the coating, subjecting the coating to reduction treatment, forming the electroless plating layer on the entire surface of the coating while simultaneously blackening the coating, forming the desired resist pattern on the electroless plating layer, and removing portions of the electroless plating layer where no resist is present and blackened portions of the coating thereunder by etching.

6. A method according to claim 3 or 5, wherein the metallic salt or the metal complex is a salt or a complex of a metal belonging to Group Ib or Group VIII of the Periodic Table of the Elements.

7. A method according to claim 2 or 4, wherein the reduced metal particles are reduced metal colloid particles or reduced metal powder obtained from a dispersion of a metal belonging to Group Ib or Group VIII of the Periodic Table of the Elements.

8. A method according to claim 5, wherein the metallic salt or the metal complex [A] is a metallic salt or a metal complex of a metal belonging to the Fourth Period of Group Ib or the Fourth Period of Group VIII of the Periodic Table of the Elements, the metallic salt or the metal complex [B] is a metallic salt or a metal complex of a metal belonging to the Fifth or Sixth Period of Group Ib or the Fifth or Sixth Period of Group VIII of the Table, and the reduced metal particles [C] are reduced metal colloid particles or reduced metal powder obtained from a dispersion of a metal belonging to Group Ib or Group VIII of the Table.

9. A method according to any preceding claim wherein the resin of the resin solution is a polyvinyl acetal.

10. A method according to claim 3, 5, 6 or 8, wherein the reduction treatment employs a reducing agent capable of reducing [A] only in the presence of a catalyst and capable of directly reducing [B].

11. A method according to claim 1, 4, 5, 8 or 10, wherein the amount of the reduced metal in the coating accounted for by Pd is 1-200 mg/m² (weight per unit area of the coating) calculated as PdCl₂.

12. A method according to any preceding claim wherein the transparent base material is glass plate, plastic film, plastic sheet or plastic plate.

13. A method according to any preceding claim wherein the transparent electromagnetic radiation shield material exhibits an optical transmittance of not less than 65% and a shielding performance of 40-80 dB in the range of 20 to 1,000 MHz.

14. An electromagnetic radiation shield material whose coating has a degree of blackness viewed from the side of a transparent substrate, expressed as optical density, of 2.9-4.0 (angle of incidence of 7 °; assuming no specular component).
